Europäisches Patentamt

(19) European Patent Office

Office européen des brevets

(11) Veröffentlichungsnummer: **0 127 750**

**A1**

(12) **EUROPÄISCHE PATENTANMELDUNG**

(21) Anmeldenummer: **84104023.1**

(22) Anmeldetag: **10.04.84**

(51) Int. Cl.³: **H 01 L 23/04**
**H 01 L 23/48, H 01 L 29/74**

(30) Priorität: **09.05.83 DE 3316964**

(43) Veröffentlichungstag der Anmeldung:
**12.12.84 Patentblatt 84/50**

(84) Benannte Vertragsstaaten:
**BE DE FR GB IT**

(71) Anmelder: **Siemens Aktiengesellschaft**
**Berlin und München Wittelsbacherplatz 2**
**D-8000 München 2(DE)**

(72) Erfinder: **Vogt, Herbert**
**Wurzerstrasse 18**
**D-8000 München 22(DE)**

(72) Erfinder: **Egerbacher, Werner**
**Vogelhartstrasse 4**
**D-8000 München 40(DE)**

(72) Erfinder: **Wunderlich, Dieter**
**Prof.-Schmid-Strasse 95**
**D-8037 Olching-Geiselbullach(DE)**

(72) Erfinder: **Mitzkus, Werner**
**Vogelhartstrasse 21**
**D-8000 München 40(DE)**

(54) **Halbleiterbauelement mit vergossenem Becher.**

(57) In einem vergossenem Becher (1) sitzt ein beidseitig mit Anschlußkörpern (3, 4) versehener Halbleiterkörper (2). Der Halbleiterkörper hat eine Steuerleitung (7), die mit einem Anschlußkontakt (12) verbunden ist. Der Anschlußkontakt ist an der Becherwand (6) befestigt und hat einen in den Raum zwischen Innenfläche der Becherwand (6) und Halbleiterkörper (2) ragenden Abschnitt (13) der elektrisch mit der Steuerleitung (7) verbunden ist.

FIG 1

SIEMENS AKTIENGESELLSCHAFT          Unser Zeichen
Berlin und München                  VPA **83 P 1325 E**

Halbleiterbauelement mit vergossenem Becher

Die Erfindung bezieht sich auf ein Halbleiterbauelement
mit den Merkmalen:

a) In einem Boden und Wand aufweisenden Becher ist ein
   Halbleiterkörper angeordnet,

b) der Halbleiterkörper ist mit zwei Anschlußkörpern kontaktiert,

c) der Boden hat eine Öffnung,

d) einer der Anschlußkörper sitzt in der Öffnung,

e) der Becher ist mindestens teilweise mit Gießharz gefüllt,

f) die Kontaktflächen der Anschlußkörper sind frei von
   Gießharz.

Ein solches Halbleiterbauelement ist beispielsweise in
der europäischen Patentanmeldung 0034208 beschrieben worden. Hierbei handelt es sich um eine Leistungsdiode. Ein
entsprechend aufgebauter Leistungsthyristor benötigt
mindestens eine Steuerleitung, die mit einem von außen
zugänglichen Anschlußkontakt zu verbinden ist.

Der Erfindung liegt die Aufgabe zugrunde, ein Halbleiterbauelement der genannten Art so weiterzubilden, daß der
Anschlußkontakt eine einfache Verbindung mit der Steuerleitung ermöglicht.

Die Erfindung ist gekennzeichnet durch die Merkmale:

g) der Halbleiterkörper ist mit mindestens einer Steuerleitung versehen,

Hab 1 Dx / 04.05.1983

0127750

h) an der Wand des Bechers ist mindestens ein Anschlußkontakt befestigt,

i) der Anschlußkontakt hat einen Abschnitt, der in den
   zwischen Wand und Halbleiterkörper liegenden Raum des
   Bechers ragt,

j) die Steuerleitung ist elektrisch mit diesem Abschnitt
   verbunden.


Weiterbildungen der Erfindung sind Gegenstand der Unteransprüche.


Die Erfindung wird anhand einiger Ausführungsbeispiele in
Verbindung mit den Fig. 1 bis 7 näher erläutert. Es zeigen:


Fig. 1 und 2   einen Schnitt und eine Aufsicht auf ein er-
               stes, besonders günstiges Ausführungsbei-
               spiel,

Fig. 3 und 4   den Schnitt und die Aufsicht auf ein zweites
               Ausführungsbeispiel,

Fig. 5         eine Einzelheit der Fig. 4,

Fig. 6         einen Schnitt durch ein drittes Ausführungsbeispiel und

Fig. 7         einen Schnitt durch ein viertes Ausführungsbeispiel der Erfindung.


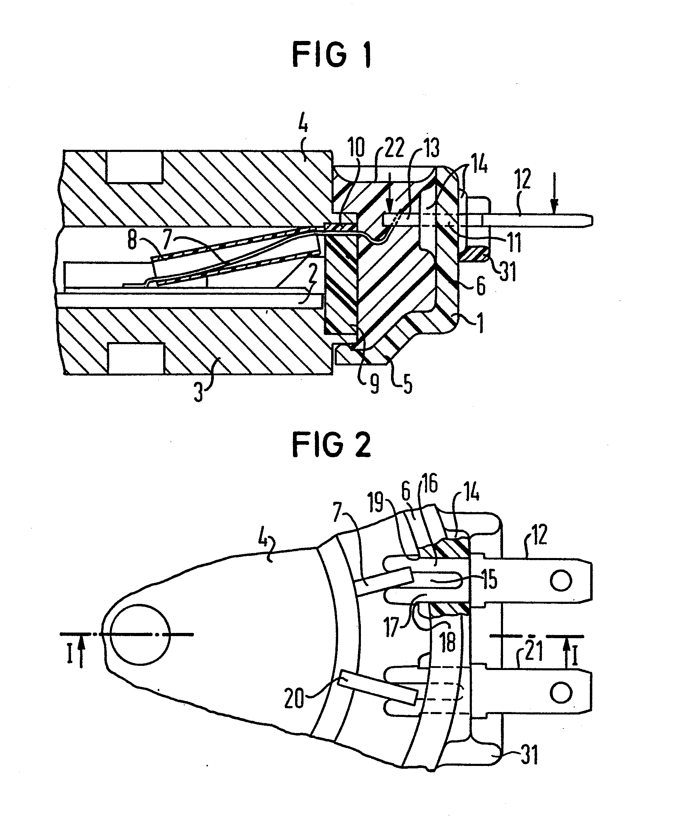

Das Halbleiterbauelement nach Fig. 1 weist einen Becher 1
auf, in dem ein von zwei Anschlußkörpern 3, 4 kontaktierter Halbleiterkörper 2 sitzt. Die gegenseitigen Kontakte
können Lötkontakte oder Druckkontakte sein. Der Becher 1
hat einen Boden 5 und eine Wand 6. Der Anschlußkörper 3
sitzt in einer Öffnung des Bodens 5. Der Halbleiterkörper 2 hat eine Steuerleitung 7, die mit dem Gatekontakt
des Halbleiterkörpers 2 verbunden ist. Die Steuerleitung
7 liegt in einem Isolierrohr, das seinerseits in einem
Schlitz des oberen Anschlußkörpers 4 angeordnet ist. Die Steuerleitung 7 ist zwischen den Stirnseiten zweier elastischer, den Halbleiterkörper umgebender Ringe 9, 10
nach außen geführt und endet innerhalb des Bechers 1. Die
Ringe 9, 10 werden mindestens während des Vergießens
stirnseitig gegeneinander gepreßt und dichten den Halbleiterkörper 2 gegen das Eindringen von Gießharz ab.

In der Wand 6 des Bechers ist eine die Wand von außen
nach innen durchdringende Öffnung 11 vorgesehen, in der
ein Anschlußkontakt 12 sitzt. Der Anschlußkontakt 12 hat
einen im Becherinneren liegenden Abschnitt 13. Die Becherwand 6 kann im Bereich der Öffnung 11 eine Verstärkung 14 aufweisen. Der Abschnitt 13 ist mit dem Ende der
Steuerleitung 7, z. B. durch Löten, verbunden. Nach dem
Verlöten wird der Becher mit Gießharz 22 gefüllt. Dieses
Gießharz sichert den Anschlußkontakt 12 in seiner Lage
insbesondere gegen Herausziehen. Die Passung zwischen der
Öffnung 11 und dem Anschlußkontakt 12 ist zweckmäßigerweise so ausgebildet, daß kein flüssiges Gießharz durch
die Öffnung 11 nach außen dringen kann.

Die Abdichtung kann durch einen engen Sitz, durch Einkleben oder durch Aufbringen eines Tropfens Gießharz an der
Innenseite der Öffnung 11 erfolgen. Das Klebemittel wird
dabei von der Innenseite des Bechers auf die Unterseite
15 der Verstärkung 14 gegeben. Diese Unterseite ist zweckmäßigerweise eben ausgebildet und bildet eine Anlauffläche für das Klebemittel.
Es ist auch möglich, den Anschlußkontakt bei der Herstellung des Bechers mit einzuspritzen oder zu umpressen.

Die Steuerleitung 7 kann mit dem Abschnitt 13 des Anschlußkontakts 12 auf einfache Weise von der offenen Seite des Bechers her verlötet werden. Die Montage läßt sich
erleichtern, wenn mindestens der in den Becherinnenraum
ragende Abschnitt 13 des Steuerkontakts 12 aus zwei Zungen 16, 17 besteht, zwischen die das Ende der Steuerleitung 7 eingelegt wird. Eine Arretierung des Steuerkontakts 12 bereits in unvergossenem Zustand läßt sich erreichen, wenn die Zungen federnd ausgebildet sind und sich in die Öffnung 11 fortsetzen (Fig. 2). Diese federnden Zungen sind mit Rasten 18, 19 versehen. Beim Einschieben des Steuerkontakts von außen werden die Zungen federnd zusammengedrückt und rasten bei vollständigem Einschieben an der Innenfläche der Becherwand ein.

Der Becher kann, wie in Fig. 2 dargestellt, mit einem zweiten Steuerkontakt 21 versehen sein, der dem Steuerkontakt 12 gleicht. Dieser kann als Hilfskatodenkontakt verwendet werden. Hierzu ist der katodenseitige Anschlußkontakt 4 über ein Bändchen 20 mit dem Hilfskatodenkontakt 21 verbunden.

Zur Verlängerung der Kriechstrecke kann die Verstärkung 14 an der Außenwand mit einem Wulst 31 versehen sein. Dieser kann die Kontakte 12, 21 ganz oder teilweise umgeben.

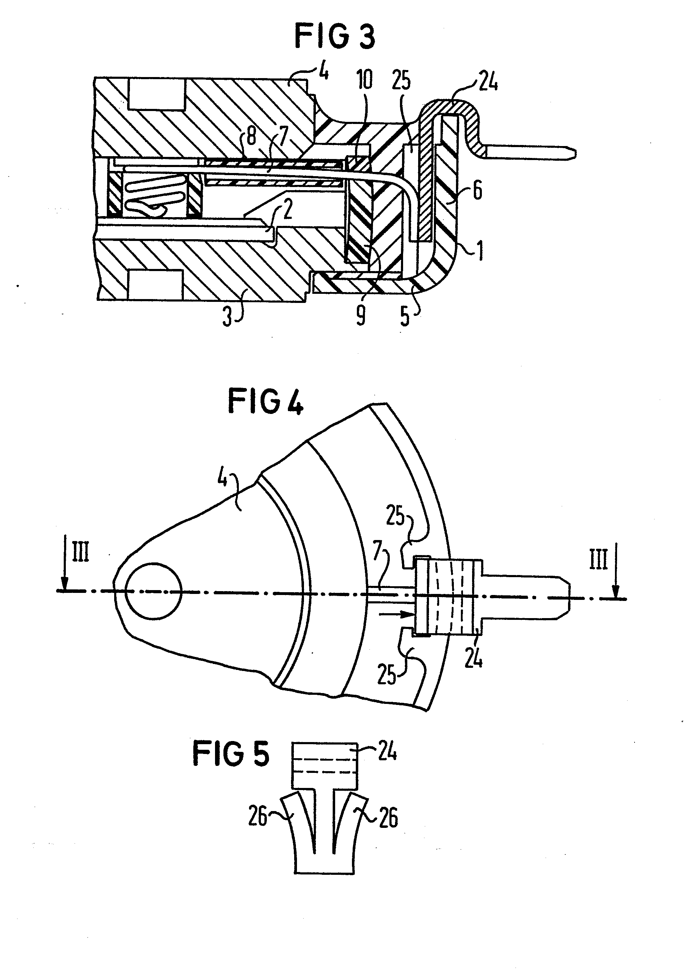

Das Ausführungsbeispiel nach Fig. 3 unterscheidet sich von dem nach Fig. 1 und 2 im wesentlichen durch die Art des Anschlußkontakts. Der Anschlußkontakt 24 ist hier ein gekröpftes Metallteil und hat einen im Becherinneren liegenden Abschnitt. Dieser Abschnitt steckt in Führungsschienen 25, die zweckmäßigerweise Bestandteil des Bechers sind. Diese Führungsschienen sind von der Oberseite des Bechers 1 gesehen offen und so ausgebildet, daß sich der Anschlußkontakt 24 von oben einschieben läßt. Die Steuerleitung 7 wird dann am Ende etwa rechtwinklig nach unten umgebogen und mit dem Ende des erwähnten Abschnitts verlötet. Fig. 4 ist die entsprechende Aufsicht auf das Halbleiterbauelement.

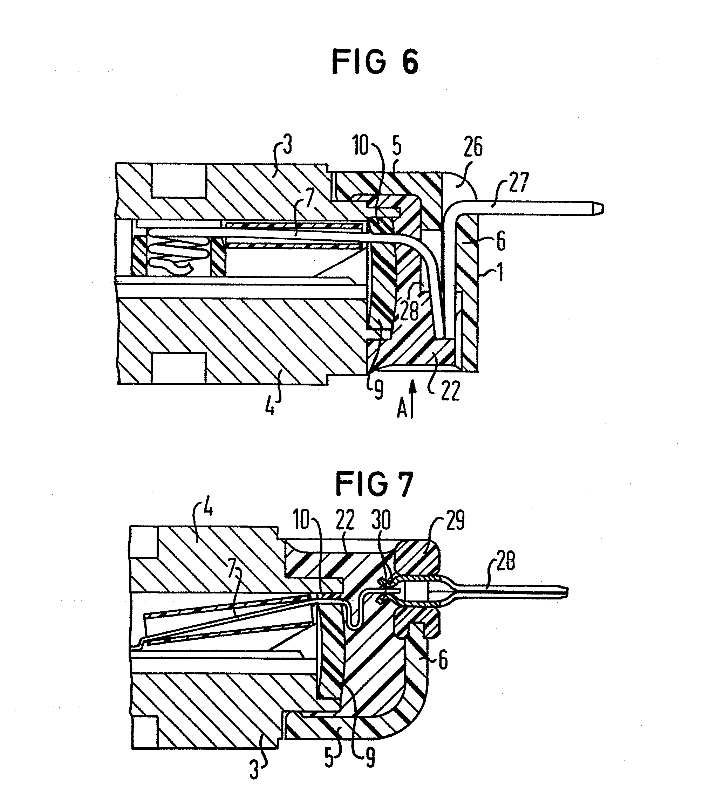

Zur Sicherung des Anschlußkontakts 24 in den Führungsschienen 25 kann der im Becherinneren liegende Abschnitt
mit zwei Spreizfedern 26 versehen sein, wie in Fig. 5
dargestellt. Diese Federn werden beim Einschieben des Anschlußkontakts 24 zusammengepreßt und verspreizen sich
in den Führungschienen 25.

Das Ausführungsbeispiel nach Fig. 6 unterscheidet sich
von dem nach Fig. 3 und 4 im wesentlichen dadurch, daß
der Anschlußkontakt nicht über den Becherrand geführt
ist, sondern durch eine im Boden 5 befindliche Öffnung
26, die in der Nähe der Innenfläche der Becherwand 6
liegt. Der Anschlußkontakt ist mit 27 bezeichnet und kann
z. B. ein Blechwinkel sein. Der Anschlußkontakt 27 weist
einen im Becherinneren liegenden Abschnitt auf, der ähnlich wie im Ausführungsbeispiel nach Fig. 3 in Führungsschienen 28 sitzt. Der Vorteil dieses Auführungsbeispiels
besteht darin, daß die Oberfläche des Vergusses 22 frei
von Metallteilen und völlig glatt ist.

Beim Ausführungsbeispiel nach Fig. 7 ist ein Anschlußkontakt 28 vorgesehen, der aus einem Rohr besteht. Dieses
Rohr wird von einer elastischen Durchführung 29 gehalten,
die ihrerseits in einem Schlitz in der Becherwand 6
sitzt. Der zum Anschluß bestimmte Teil des Anschlußkontakts 28 ist entweder rechteckig oder zylindrisch zusammengequetscht. Die Steuerleitung 7 wird mit dem Rohr wieder durch den im Becherinneren liegenden Abschnitt 30 des
Steuerkontakts verbunden. Zu diesem Zweck ist dieser Abschnitt nur soweit verformt, daß die Steuerleitung noch
eingeschoben werden kann. Sie kann dann mit dem Abschnitt
30 verlötet werden. Anschließend wird der Becher mit der
Vergußmasse 22 gefüllt.

12 Patentansprüche
7 Figuren

Patentansprüche

1. Halbleiterbauelement mit den Merkmalen:

a) In einem Boden (5) und Wand (6) aufweisenden Becher (1) ist ein Halbleiterkörper (2) angeordnet,

b) der Halbleiterkörper ist mit zwei Anschlußkörpern (3, 4) kontaktiert,

c) der Boden (5) hat eine Öffnung,

d) einer der Anschlußkörper (3) sitzt in der Öffnung,

e) der Becher ist mindestens teilweise mit Gießharz (22) gefüllt,

f) die Kontaktflächen der Anschlußkörper sind frei von Gießharz,

g e k e n n z e i c h n e t    durch die Merkmale:

g) der Halbleiterkörper (2) ist mit mindestens einer Steuerleitung (7) versehen,

h) an der Wand (6) des Bechers ist mindestens ein Anschlußkontakt (12) befestigt,

i) der Anschlußkontakt hat einen Abschnitt (13), der in den zwischen Wand (6) und Halbleiterkörper (2) liegenden Raum des Bechers (1) ragt,

j) die Steuerleitung (7) ist elektrisch mit diesem Abschnitt (13) verbunden.

2. Halbleiterbauelement nach Anspruch 1, d a d u r c h g e k e n n z e i c h n e t , daß der Anschlußkontakt (12) in einer Öffnung (11) steckt, die die Becherwand (6) von der Außenseite zur Innenseite durchdringt.

3. Halbleiterbauelement nach Anspruch 1, d a d u r c h g e k e n n z e i c h n e t , daß die Becherwand (6) im Bereich der Öffnung (11) mit einer Verstärkung (14) versehen ist.

4. Halbleiterbauelement nach Anspruch 3, d a d u r c h
g e k e n n z e i c h n e t , daß die Verstärkung (14)
auf der Außenseite der Becherwand (6) einen Wulst (31)
aufweist, der den Anschlußkontakt (12) mindestens teilweise umgibt.

5. Halbleiterbauelement nach Anspruch 2, 3 oder 4,
d a d u r c h   g e k e n n z e i c h n e t , daß der
in der Öffnung (11) steckende Teil des Anschlußkontakts
(12) federnd ausgebildet und von außen einsteckbar und
einrastend in der Öffnung gehalten ist.

6. Halbleiterbauelement nach Anspruch 5, d a d u r c h
g e k e n n z e i c h n e t , daß der in den Becher (1)
ragende Abschnitt und der in der Öffnung steckende Teil
aus zwei beabstandeten federnden Zungen (16, 17) besteht,
und daß die Steuerleitung (7) zwischen beiden Zungen
elektrisch mit dem Anschlußkontakt (12) verbunden ist.

7. Halbleiterbauelement nach Anspruch 2, 3 oder 4,
d a d u r c h   g e k e n n z e i c h n e t , daß der
Anschlußkontakt (12) in der Öffnung festgeklebt ist.

8. Halbleiterbauelement nach einem der Ansprüche 1 bis 7,
d a d u r c h   g e k e n n z e i c h n e t , daß der
in den Becher ragende Abschnitt (13) des Anschlußkontakts
(12) in die Gießharzmasse (22) eingebettet ist.

9. Halbleiterbauelement nach Anspruch 1, d a d u r c h
g e k e n n z e i c h n e t , daß der Anschlußkontakt
ein gekröpftes Metallteil (24) ist, das über den Rand der
Becherwand (6) geht, daß an der Innenseite der Becherwand
von der offenen Seite des Bechers zugängliche Führungsschienen (25) angebracht sind und daß der in den Becher
ragende Abschnitt des Anschlußkontakts (24) mindestens
teilweise in den Führungsschienen steckt.

0127750

10. Halbleiterbauelement nach Anspruch 1, d a d u r c h
g e k e n n z e i c h n e t , daß der Boden (5) des Bechers eine der Innenseite der Becherwand (6) benachbarte
Öffnung (26) aufweist, daß an der Innenseite der Becherwand von der offenen Seite des Bechers zugängliche Führungsschienen (28) vorgesehen sind und daß der in den Becher ragende Abschnitt des Anschlußkontakts (27) mindestens teilweise in den Führungsschienen steckt.

11. Halbleiterbauelement nach Anspruch 9 oder 10, d a -
d u r c h   g e k e n n z e i c h n e t ,   daß der in
den Führungsschienen steckende Teil des Anschlußkontakts
(24, 27) als Spreizfeder (26) ausgebildet ist.

12. Halbleiterbauelement nach Anspruch 1, d a d u r c h
g e k e n n z e i c h n e t ,   daß in der Becherwand (6)
eine elastische Durchführung (29) sitzt, und daß der Anschlußkontakt (28) in der Durchführung sitzt und von dieser festgeklemmt ist.

# FIG 1

# FIG 2

FIG 3

FIG 4

FIG 5

0127750

## FIG 6

## FIG 7

0127750

Nummer der Anmeldung

EP 84 10 4023

## EUROPÄISCHER RECHERCHENBERICHT

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| A | US-A-3 992 717 (RICE) <br> * Spalte 3, Zeile 54 - Spalte 4, Zeile 26; Figur 2 * | 1,2 | H 01 L 23/04 <br> H 01 L 23/48 <br> H 01 L 29/74 |
| A | GB-A-1 358 504 (WESTINGHOUSE) <br> * Seite 3, Zeilen 33-52; Figur 2 * | 1-3,8 | |
| A | DE-A-2 013 742 (GE) <br> * Figur 1 * | 1 | |
| A,D | EP-A-0 034 208 (BOSCH) <br> * Seite 2 ; Figur * | 1 | |

RECHERCHIERTE
SACHGEBIETE (Int. Cl. ³)

H 01 L 23/04
H 01 L 23/48
H 01 L 29/74

Der vorliegende Recherchenbericht wurde für alle Patentansprüche erstellt.

| Recherchenort | Abschlußdatum der Recherche | Prüfer |
|---|---|---|
| BERLIN | 07-08-1984 | ROTHER A H J |